Europäisches Patentamt

European Patent Office

Office européen des brevets

(19)

(11)     EP 0 888 464 B1

(12)     EUROPÄISCHE PATENTSCHRIFT

(45) Veröffentlichungstag und Bekanntmachung des Hinweises auf die Patenterteilung:
**02.10.2002   Patentblatt 2002/40**

(51) Int Cl.⁷: **C23C 14/35**, C23C 14/34, H01J 37/34

(21) Anmeldenummer: **97906078.7**

(22) Anmeldetag: **19.03.1997**

(86) Internationale Anmeldenummer:
**PCT/CH97/00114**

(87) Internationale Veröffentlichungsnummer:
**WO 97/035043 (25.09.1997 Gazette 1997/41)**

(54) **TARGET, MAGNETRONQUELLE MIT EINEM SOLCHEN UND VERFAHREN ZUR HERSTELLUNG EINES SOLCHEN TARGETS**

TARGET, MAGNETRON SOURCE WITH SAID TARGET, AND PROCESS FOR PRODUCING SAID TARGET

CIBLE, SOURCE DE MAGNETRON AVEC UNE CIBLE, ET PROCEDE POUR LA FABRICATION D'UNE TELLE CIBLE

(84) Benannte Vertragsstaaten:
**AT BE CH DE DK ES FR GB IE IT LI NL PT SE**

(30) Priorität: **19.03.1996   CH 72496**

(43) Veröffentlichungstag der Anmeldung:
**07.01.1999   Patentblatt 1999/01**

(73) Patentinhaber: **Unaxis Balzers Aktiengesellschaft**
**9496 Balzers (LI)**

(72) Erfinder:
 • **QUADERER, Hans**
  **FL-9494 Schaan (LI)**
 • **WEICHART, Jürgen**
  **FL-9496 Balzers (LI)**

(74) Vertreter: **Troesch Scheidegger Werner AG**
**Patentanwälte**
**Postfach**
**8032 Zürich (CH)**

(56) Entgegenhaltungen:
**US-A- 4 401 546          US-A- 4 865 708**
**US-A- 4 879 017**

 • **PATENT ABSTRACTS OF JAPAN vol. 012, no. 365 (C-532), 29.September 1988 & JP 63 118067 A (TOHOKU METAL IND LTD), 23.Mai 1988,**
 • **PATENT ABSTRACTS OF JAPAN vol. 010, no. 288 (P-502), 30.September 1986 & JP 61 105610 A (CITIZEN WATCH CO LTD), 23.Mai 1986,**

**Beschreibung**

Die vorliegende Erfindung betrifft ein Target aus ferromagnetischem Material, eine Magnetronquelle, eine Magnetronsputteranlage und ein Verfahren zur Herstellung eines Targets aus ferromagnetischem Material.

Bekanntlich weisen Magnetronzerstäubungsquellen ein Target auf sowie eine darunterliegende Magnetanordnung. Diese erzeugt über der Zerstäubungsfläche des Targets ein üblicherweise in sich geschleiftes, tunnelförmiges Streufeld, welches für die Wirkung der Zerstäubungsquelle als Magnetronzerstäubungsquelle ausschlaggebend ist. Beim Magnetronzerstäuben von Targets aus ferromagnetischem Material wirken letztere als magnetischer Kurzschluss. Damit ist nur bei relativ dünnen Targetplatten ein genügendes tunnelförmiges Streufeld realisierbar oder es müssen sehr starke Magnete eingesetzt werden. Trotzdem bleibt aber die Standzeit des Targets und dessen Materialausbeute gering, weil, sobald die Bildung des Erosionsgrabens am Target beginnt, die Streufeldstärke im Grabenbereich zunimmt, was, im Sinne eines mitgekoppelten Systems, zu einer zunehmenden Einschnürung des Erosionsgrabens führt, mit entsprechend schlechter Ausbeute des Targetmaterials bzw. hohem Rateverlust durch Zerstäubungsablagerung am Target.

Aus den US-4 401 546, US-4 412 907 und DE-A-32 23 245 ist es bekannt, dieses Problem dadurch zu lösen, dass die auf eine Trägerplatte gebondete Targetplatte durch Schlitze bis auf die Trägerplatte segmentiert wird. Die Unterteilung der Targetplatte in Einzelteile ist ausserordentlich aufwendig. Hinzu kommt, dass durch geeignete Gestaltung der Zwischenräume sicherzustellen ist, die Verunreinigung des Zerstäubungsprozesses durch Trägerplattenmaterial möglichst gering zu halten.

Die US-4 299 678 lehrt, das oben angesprochene Problem dadurch anzugehen, dass in die Targetplatte nicht durchgehende Nuten eingearbeitet werden, aber dafür das ferromagnetische Targetmaterial über die Curie-Temperatur erhitzt wird.

Nebst der Einarbeitung der umlaufenden Nutenmuster ist hier insbesondere das Beheizen des Targets ausserordentlich aufwendig, bedingt doch dies, beispielsweise für ein Nickeltarget, eine Aufheizung auf über 350°C.

Schliesslich sind aus der EP-0 210 858 Targets mit Sacklochmusterung bekannt. Sie werden für Nicht-Magnetron-Hochfrequenzsputtern eingesetzt und bestehen beispielsweise aus Mo, Cu, C oder $SiO_2$. Auch andere metallische und dielektrische Materialien können eingesetzt werden. Dabei sind die Sacklöcher so dimensioniert, dass darin jeweils eine Hohlkathodenentladung brennt, wodurch eine besonders hohe Plasmadichte erreicht werden soll. Hier wird, für Hf-Sputtern, ein Alternativweg zum bei Hf-Anwendungen eher seltenen Magnetronzerstäuben gegangen.

Es ist Aufgabe der vorliegenden Erfindung, ein Target aus ferromagnetischem Material, eine Magnetronquelle mit einem solchen Target, weiter eine Magnetronsputteranlage mit einer solchen Quelle zu schaffen, woran bezüglich Target hohe Standzeiten bei guter Materialausnützung erreicht werden. Dabei sollen die Targets bevorzugterweise rechteckförmig oder kreisplattenförmig sein. Im weiteren ist es Aufgabe der vorliegenden Erfindung, ein Herstellverfahren für solche Targets vorzuschlagen.

Die obgenannte Aufgabe wird am erwähnten Target dadurch gelöst, dass entlang seiner Zerstäubungsfläche ein Muster von Sacklöchern vorgesehen ist.

Die Erfindung wird anschliessend beispielsweise anhand von Figuren erläutert.

Diese zeigen:

Fig. 1a bis 1f     je einen Ausschnitt aus einem erfindungsgemässen Target, jeweils mit einer Ausführungsform der erfindungsgemäss vorgesehenen Sackbohrungen;

Fig. 2     schematisch einen Ausschnitt aus einer erfindungsgemässen Magnetronquelle mit einem erfindungsgemässen Target, auch zur Definition der in der Beschreibung verwendeten Grössen;

Fig. 3     eine bevorzugte Ausführungsform eines erfindungsgemässen Rundtargets mit Minimallochmusterung;

Fig. 4     die Aufsicht auf ein erfindungsgemässes Rechtecktarget mit verbesserter Lochmusterung;

Fig. 5     die berechnete Streufeldüberhöhung an einem versetzten Einzelsackloch am Target der Quelle nach Fig. 2;

Fig. 6     den Vergleich der nach Fig. 5 berechneten Streufeldüberhöhung mit der gemessenen, in x-Richtung eines x/y/z-Koordinatensystems (s. Definitionen);

Fig. 7     eine Darstellung analog zu Fig. 6, betrachtet in y-Richtung;

Fig. 8     den Verlauf der maximalen Streufeldüberhöhung an drei Einzelsacklöchern unterschiedlicher Durchmesser bei unterschiedlichem Versatz (s. Definitionen);

Fig. 9     den bei vier nebeneinanderliegenden Sacklöchern durch Ueberlagerung resultierenden Magnetfeldverlauf;

Fig. 10 den Verlauf der Nutzzerstäubungsrate an einem gemäss Fig. 4 strukturierten Nickeltarget in Funktion der Targetlebensdauer;

Fig. 11 ein Funktionsblock/Signalflussdiagramm einer nach dem erfindungsgemässen Verfahren arbeitenden erfindungsgemässen Targetherstellanlage und

Fig. 12 eine besonders bevorzugte Ausführungsform eines erfindungsgemässen Rechtecktargets in einer Darstellung analog zu Fig. 4.

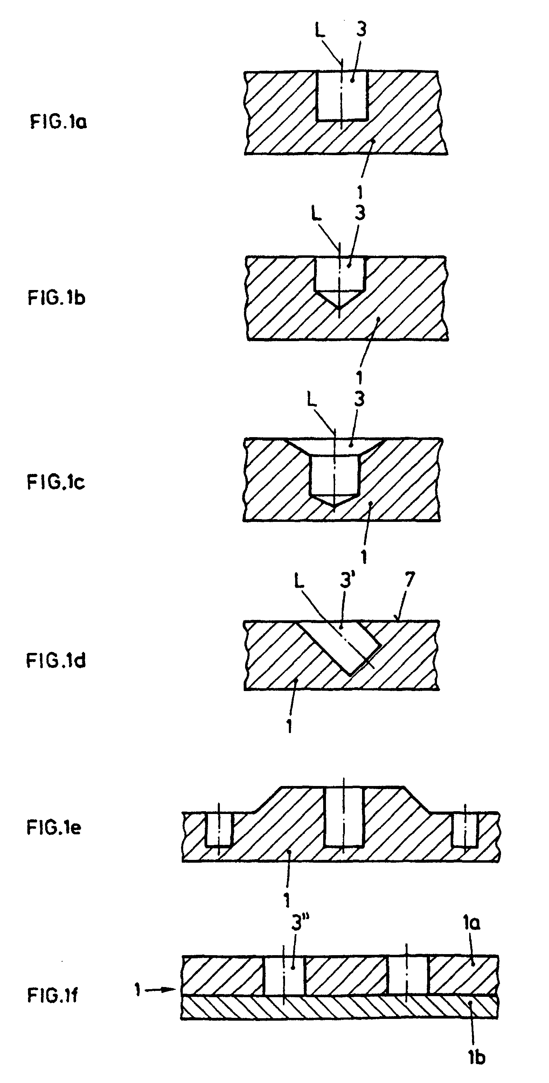

Nach Fig. 1 weist ein erfindungsgemässes Target aus ferromagnetischem Material, dabei insbesondere aus Nickel oder einer Nickellegierung, wie NiFe, an seiner Zerstäubungsfläche ein Muster von Sacklöchern auf. Diese können in die Targetplatte 1, wie beispielsweise anhand der Fig. 1a bis 1c dargestellt, eingearbeitet sein, beispielsweise eingebohrt sein. Vorzugsweise sind die Sacklöcher 3 zur Achse L rotationssymmetrisch.

Gemäss Fig. 1d können die erfindungsgemäss vorgesehenen Sacklöcher 3, wie bei 3' dargestellt, auch schiefwinklig bezüglich der Zerstäubungsneufläche 7 des Targets eingearbeitet sein.

Gemäss Fig. 1e kann weiter die Dickenausdehnung des Targets 1 bei Ausführung der erfindungsgemäss vorgesehenen Sacklöcher nach einer oder mehreren der anhand der Fig. 1a bis 1d dargestellten Ausführungsformen gestuft sein, womit ebenfalls der Verlauf des Tunnelfeldes beeinflusst wird.

Gemäss Fig. 1f ist das Target, wiederum versehen mit Sacklöchern gemäss einer der Fig. 1a bis 1d, zweiteilig ausgebildet mit einer oberen Platte 1a und einer unteren 1b, vorzugsweise aus gleichen Materialien. Die obere Platte 1a ist zur Erstellung der Sacklöcher 3'' durchgebohrt. Dies kann z.B. wesentliche Fertigungsvorteile mit sich bringen.

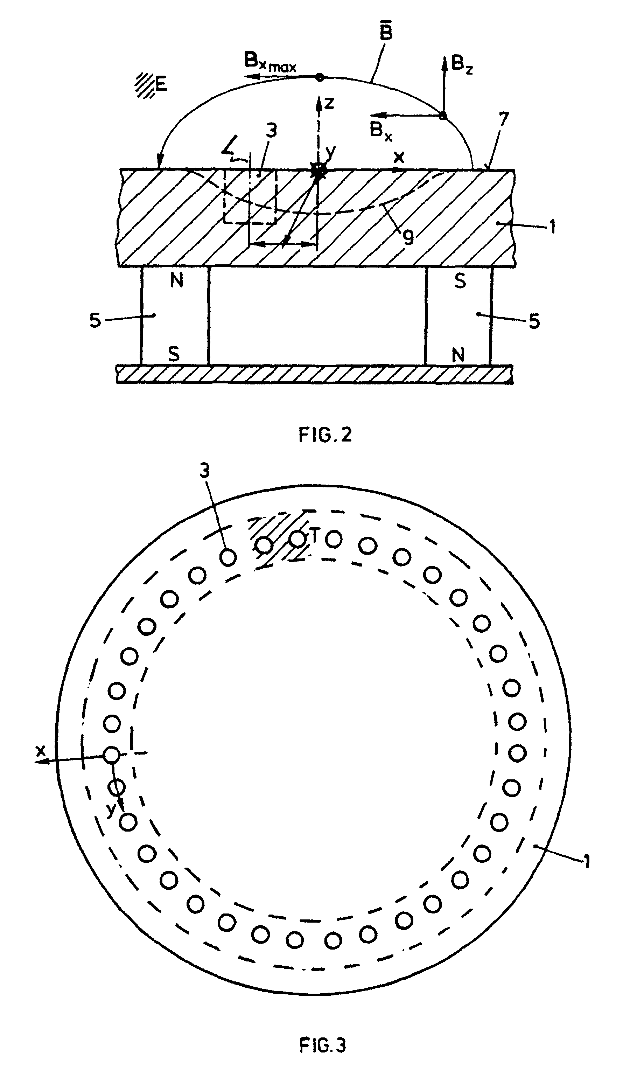

Anhand von Fig. 2 werden nachfolgend verwendete Grössen definiert.

Fig. 2 zeigt schematisch einen Ausschnitt aus einer erfindungsgemässen Magnetronquelle mit erfindungsgemässem Target 1. Gestrichelt ist eines der mehreren, erfindungsgemäss vorgesehenen Sacklöcher 3 dargestellt. Die Magnetanordnung 5 erzeugt das tunnelförmige Streufeld $\bar{B}$.

Definitionen:

- Tunnelfeld: Das Gesamtfeldmuster des aus der Targetzerstäubungsfläche austretenden und in diese wieder eintretenden magnetischen Streufeldes $\bar{B}$ der Magnetronquelle, mit Komponente $B_z$ senkrecht zur Zerstäubungsneufläche 7 und der Komponente $B_x$ parallel zur Neufläche 7. Die Feldlinien $\bar{B}$ verlaufen in jeweiligen Ebenen E senkrecht zur Neufläche 7.

- Tunnelachse y: entsprechend Koordinatenachse y: Ort auf der Neufläche 7, worüber $B_x$ maximal ist und $B_z$ verschwindend.

- x-Koordinate x/y/z-System: mit dem Ursprung auf der Tunnelachse y, senkrecht zu y in der Neufläche 7. Daraus ergibt sich das System x/y/z.

- Erosionsgraben 9: Der sich im wesentlichen unter dem Bereich T des Tunnelfeldes $\bar{B}$ erstreckende, zunehmend tiefe Bereich abgestäubten Materials.

- Neufläche 7: Unzerstäubte Targetzerstäubungsfläche.

- Feldstärke $B_{ox}$: Die sich bei nicht gelochter Neufläche 7 unmittelbar an ihrer Oberfläche ergebende Feldstärkekomponente in x-Richtung.

- $B_{\ell x}$: Die sich im Bereich eines erfindungsgemäss vorgesehenen Sackloches einstellende Feldstärke in x-Richtung.

- $B_{\ell x max}$: Deren Maximalwert.
  $\Delta B_x$: Streufeldüberhöhung, die Differenz des an einem Ort im Bereiche eines erfindungsgemäss vorgesehenen Sackloches gemessenen Feldes $B_{\ell x}$ und dem am gleichen Orte gemessenen Feldes $B_{ox}$.

- $B_{rx}$: Der bei Vorsehen mehrerer Sacklöcher daraus resultierende Feldverlauf in x-Richtung.

- Lochversatz V: Der Versatz der Zentralachse L eines erfindungsgemäss vorgesehenen Sackloches senkrecht zur Tunnelachse y.

- Nutzzerstäubungsrate NZ: Die pro kWh elektrische Leistung zerstäubte und über dem Target nutzbare Materialmenge in g.

- Nutzungsgrad N: In Prozent, der Anteil des über der erodierten Targetfläche nutzbaren zerstäubten Materials, bezogen auf das Neugewicht des Targets.

Erfindungsgemäss kann durch die Verteilung der vorgesehenen Sackbohrungen 3 in der Targetzerstäubungsfläche das Tunnelfeld gezielt beeinflusst werden, um so einerseits die Nutzabstäubungsratenverteilung, die Nutzabstäubungsrate an sich bzw. das entstehende Erosionsprofil gezielt zu gestalten.

In Fig. 3 ist ein erfindungsgemässes Rundtarget in einfacher Ausführungsform dargestellt. Im Bereiche T ist erfindungsgemäss ein Muster von Sacklöchern 3 vorgesehen, bevorzugterweise eine in sich geschlossene Schleife definierend, bevorzugterweise ebenfalls eine Kreisschleife in T. Durch selektive Auslegung der Lochabstände in y-Richtung, des Versatzes V und der Lochdurchmesser sowie der Lochprofilierung (s. z.B. Fig. 1c), weiter der Ausrichtung der Lochachsen L (s. z. B. Fig. 1d) und/oder der Dickenprofilierung (s. z.B. Fig. 1e) kann das resultierende Feld $B_{rx}$ in weiten Grenzen nach Wunsch gestaltet werden.

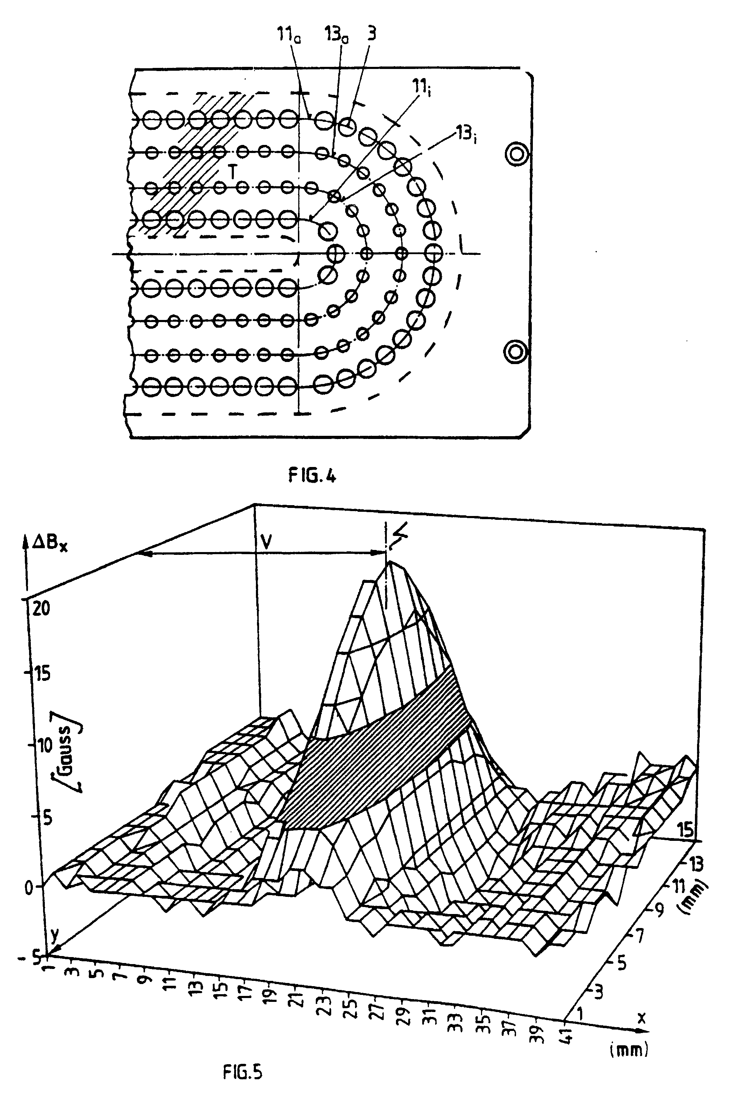

In Fig. 4 ist in Aufsicht ein Endabschnitt eines Rechtecktargets dargestellt. Wie ersichtlich, sind hier vier Schleifen von Sacklöchern 3 vorgesehen, eine äusserste $11_a$ und eine innerste $11_i$ mit Sacklöchern grösseren Durchmessers. Dazwischen liegen zwei Schleifenmuster $13_a$ und $13_i$ von Sacklöchern kleineren Durchmessers. Durch eine Anordnung mit mehreren Schleifenmustern in bzw. nahe an T wird es möglich, darüber z.B. ein optimal homogenes Feld $B_{rx}$ zu realisieren.

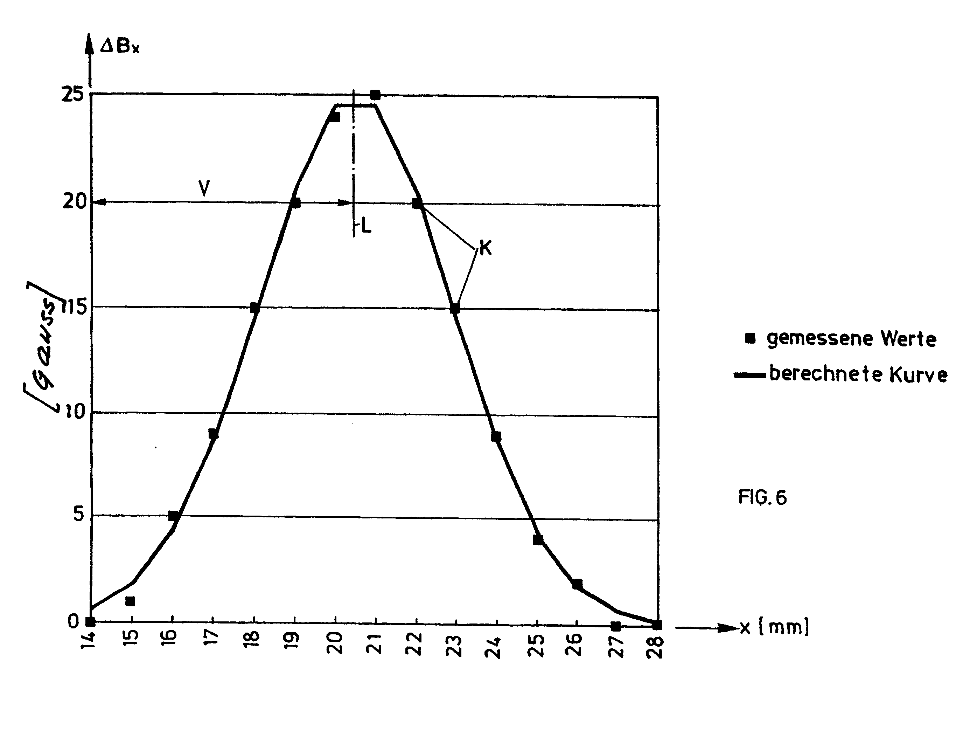

In Fig. 5 ist $\Delta B_x$ in einer Höhe von 5mm über einem 4mm-Einzelloch in einem 11mm-dicken Ni-Target aufgenommen mit einem Magnetsystem, wie es an der Magnetronquelle AK 517, die von der Anmelderin vertrieben wird, eingesetzt ist.

Fig. 6 zeigt mit Punktmarkierungen K Werte von $\Delta B_x$, gemessen an einem 4mm-Einzelsackloch im 11mm Nickeltarget mit dem erwähnten Magnetsystem, sowie den mit einer Gauss-Funktion berechnet angepassten Verlauf. Die Uebereinstimmung ist augenfällig.

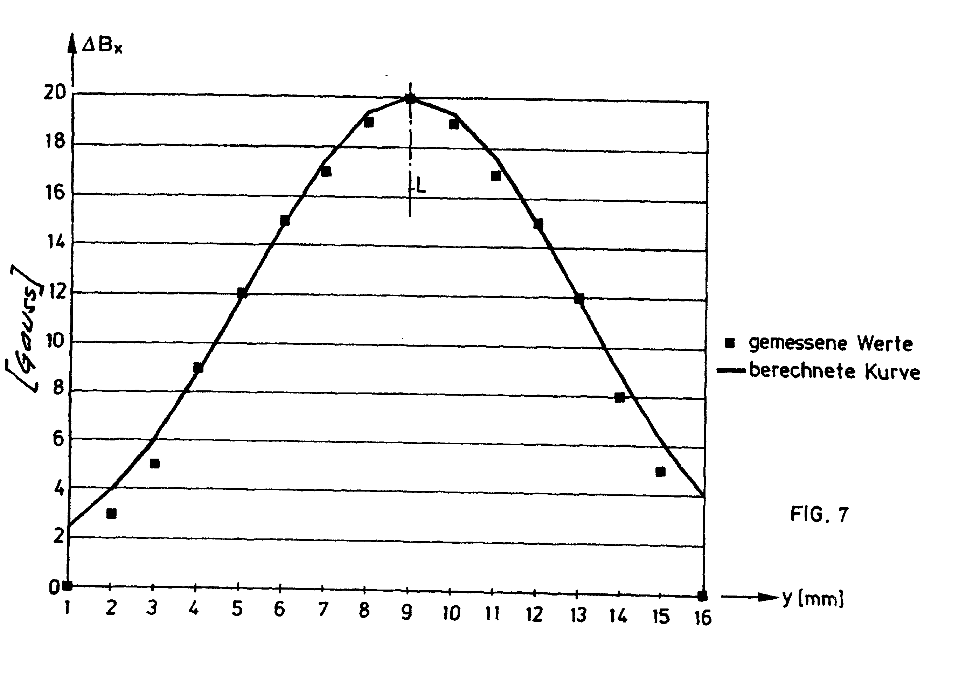

Während in Fig. 6 der Gauss-Funktion ähnliche Verlauf der Magnetfeldüberhöhung $\Delta B_x$ in einer z/x-Ebene dargestellt ist, stellt Fig. 7 den erwähnten Vergleich an demselben Einzelsackloch, betrachtet in der z/y-Ebene, dar, jeweils durch L.

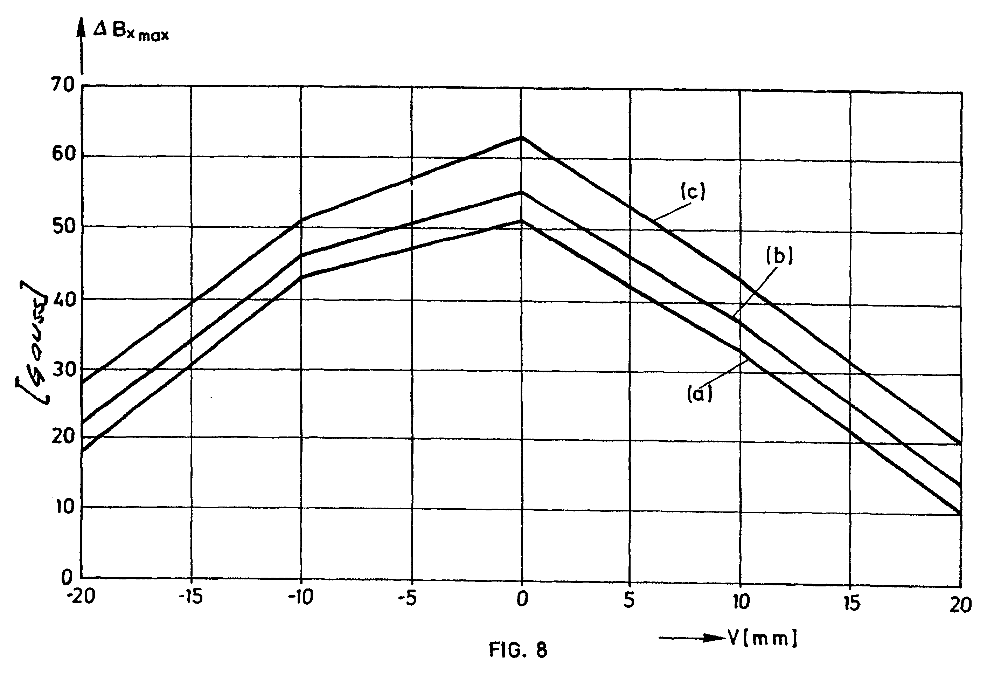

In Fig. 8 ist in Funktion von V für Einzelsacklöcher der Durchmesser 4mm (a), 5mm (b), 6mm (c) im 11mm-Ni-Target bei Einsatz des erwähnten Magnetsystems, die Maximum Magnetfeldüberhöhung $\Delta B_{xmax}$, gemessen über 5mm der Neufläche und dem jeweiligen Lochzentrum L, dargestellt.

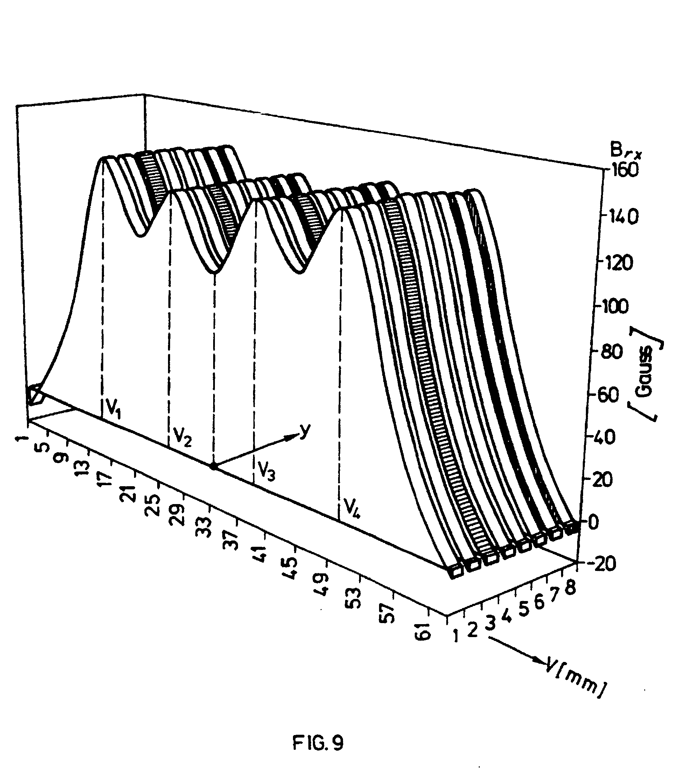

In Fig. 9 ist das resultierende Magnetfeld $B_{rx}$ dargestellt, wenn, mit dem entsprechenden Versatz $V_1$ bis $V_4$ in T und bezüglich der y-Tunnelachse zentriert, vier Sackbohrungen vorgesehen werden, je mit einem Durchmesser von 4mm, wiederum in einem 11mm-dicken Ni-Target und mit der erwähnten Magnetanordnung. Daraus ist ersichtlich, dass sich $B_{rx}$, hier in 5mm Höhe über der Zerstäubungsfläche gemessen bzw. gerechnet, durch additive Ueberlagerung der Gauss-ähnlichen Verteilungen von $B_{\ell x}$ bzw. $\Delta B_x$ der Einzelsacklöcher ermitteln lässt.

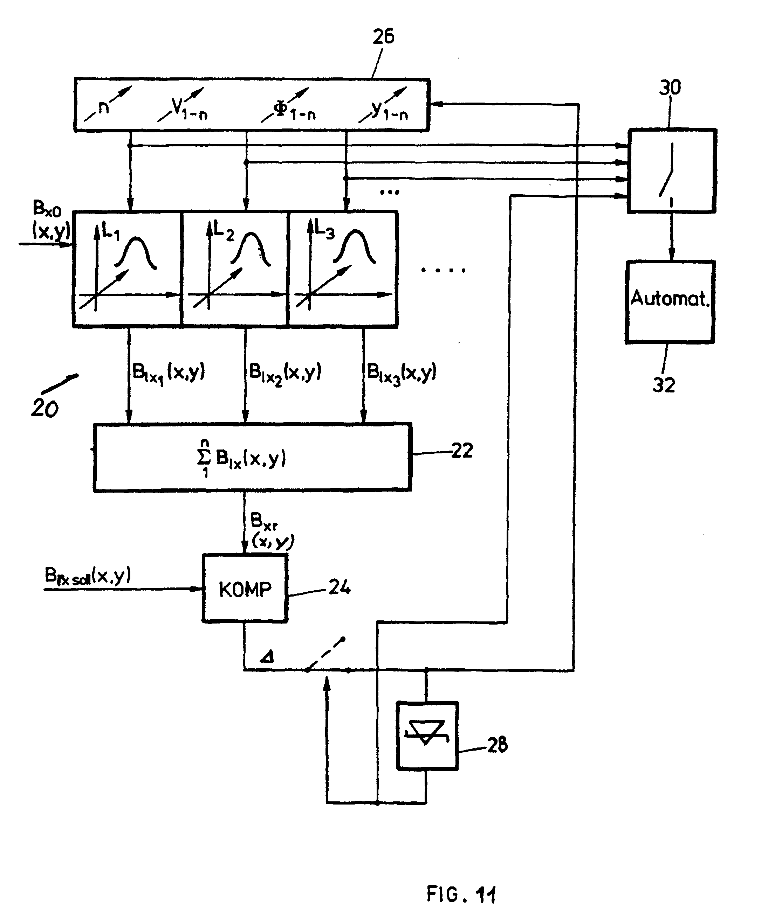

In Fig. 11 ist anhand eines Funktionsblock-Signalflussdiagrammes das erfindungsgemässe Herstellverfahren einerseits, anderseits der Aufbau einer Anlage zu dessen Ausführung dargestellt. Einem Rechner 20 werden von einer gegebenen Anzahl n Einzelsacklöcher bei vorgegebener Magnetfeld-$B_{xo}(x, y)$-Verteilung, bei je gegebenem Versatz $V_{1-n}$, gegebenem Durchmesser $\Phi_{1-n}$ und der gegebenen y-Lage $y_{1-n}$, weiter bei gegebenem Lochprofil und gegebener Schräglage und bei gegebener Targetdicke, die gemessenen oder gerechneten Einzelloch-Magnetfelder $B_{\ell x1-n}$ eingegeben. Diese werden an der Recheneinheit 22 additiv überlagert. Es resultiert der Verlauf des Magnetfeldes $B_{rx}(x, y)$. Dies entsprechend der Summation der Einzelloch-Magnetfeldverläufe, z.B. gemäss Fig. 5 zum resultierenden Magnetfeldverlauf, z.B. gemäss Fig. 9.

An einer Vergleichseinheit 24 wird der errechnete resultierende Verlauf $B_{xr}(x, y)$ mit einem vorgegebenen, erwünschten SOLL-Verlauf $B_{\ell xSOLL}(x, y)$ verglichen. Mit dem resultierenden Abweichungsverlauf $\Delta$ werden automatisch an der Vorgabeeinheit für die $B_{\ell x}(x, y)$ 26 die Lochversatze $V_{1-n}$ und/oder die Durchmesser $\Phi_{1-n}$ und/oder die Lochpositionen x, y und/oder die Lochprofile und/oder die Loch-Schräglagen und/oder die Target-Dicke so lange verändert, bis der resultierende Feldverlauf $B_{rx}(x, y)$ mit geforderter Genauigkeit dem SOLL-Verlauf $B_{rxSOLL}(x, y)$ entspricht. Dann wird, wie mit der Komparatoreinheit 28 schematisch dargestellt, der iterative Rückführungsprozess $\Delta$ unterbrochen, die dann ermittelten geometrischen Daten für Lage, Profil, Schräglage, Dicke und Lochdurchmesser, wie schematisch mit der Schalteinheit 30 dargestellt, gegebenenfalls über Zwischenspeicherung, an einen Werkzeugautomaten 32 für die Targetlochung übertragen.

Mit Vorgabe des SOLL-Verlaufes $B_{rxSOLL}(x, y)$ wird eine möglichst hohe Streufeldstärke angestrebt, weiter ein möglichst breites Streufeldprofil über der Targetneufläche. An der Vorgabeeinheit 26 werden im weiteren vorzugsweise nicht nur die erwähnten Lochparameter, nämlich geometrische Lage, Profil, Schräglage, örtliche Dicke der Targetplatte, variiert, sondern auch die verwendete Lochzahl n, um den SOLL-Verlauf mit geforderter Näherung zu realisieren, und zwar mit einer möglichst geringen Sacklochzahl. Bei der Wahl des SOLL-Feldverlaufes werden Erfahrungswerte über den entsprechenden Verlauf der Targeterosion berücksichtigt.

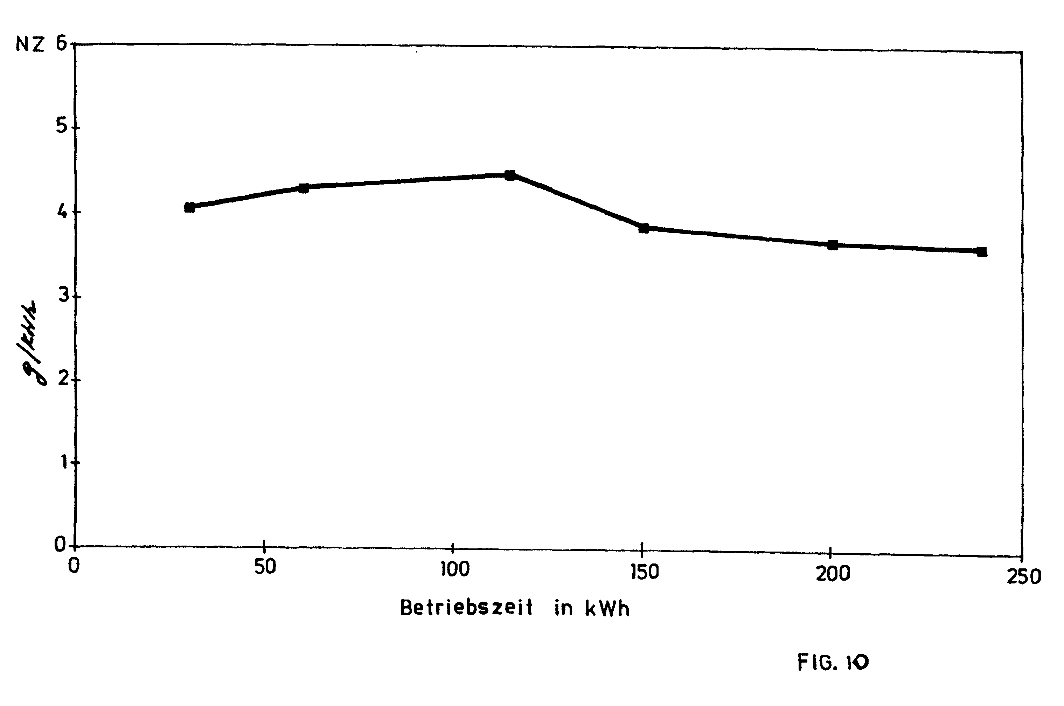

In Fig. 10 ist die gemessene NZ an einem erfindungsgemäss strukturierten Ni-Target von 11mm Dikke mit der Ausdehnung 5" x 17", und ausgelegt wie in Fig. 4 dargestellt, abgetragen, woraus ersichtlich ist, dass in Funktion der Targetbetriebszeit in kWh die genutzte abgesputterte Materialrate nur unwesentlich abnimmt und damit die Verlustrate nur unwesentlich zunimmt.

Bei den erfindungsgemässen Targets, beispielsweise gemäss Fig. 4, wurde N bei erfindungsgemässen Ni-Targets von 18% gemessen, gegenüber nur 13% bei unstrukturierten Ni-Targets.

Mit den erfindungsgemässen Targets aus ferromagnetischem Material wird es möglich, wesentlich dickere Targetplatten einzusetzen und damit die Targetstandzeit deutlich zu verlängern. Vorsehen einer Trägerplatte für das Target erübrigt sich oft. Die Erosionsgraben sind, verglichen mit Nicht-Sackloch-profilierten Targets aus demselben ferromagnetischen Material, wenig eingeschnürt. Dies ergibt eine wesentliche Erhöhung von N.

Im weiteren wurde eine Verbesserung von NZ bezüglich lokaler Homogenität festgestellt, was sich u. a. aus der erwähnten Verbreiterung des Erosionsgrabens erklärt. Daraus ist ersichtlich, dass durch gezielte Verteilung der Sacklochmusterung sich auch gezielt die Verteilung von NZ gezielt beeinflussen lässt.

Die Erstellung eines Lochmusters im Target ist äusserst kostengünstig, und durch das erfindungsgemässe Herstellverfahren können gezielt erwünschte Feldverläufe des Tunnelfeldes realisiert werden.

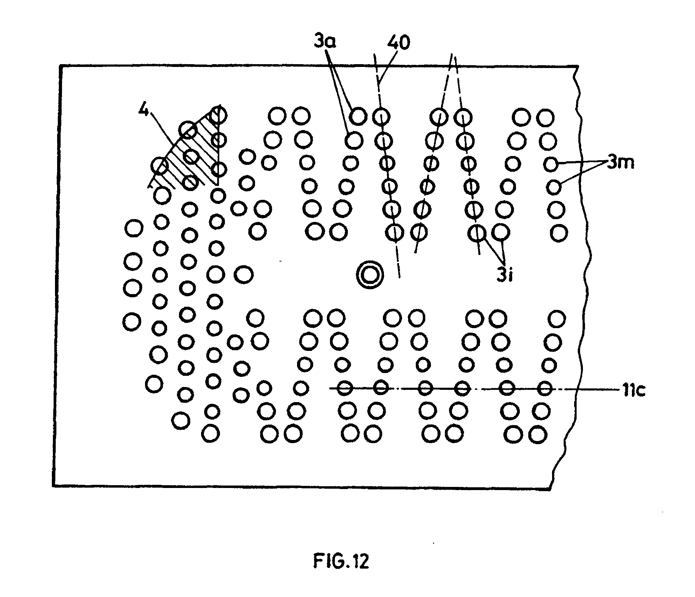

Schliesslich ist in Fig. 12 ein besonders bevorzugtes Muster an einem Rechtecktarget dargestellt. Es umfasst Lochreihen 40, die, entlang den Target-Längsseiten, zick-zack-förmig nach innen angeordnet sind. Die äusseren Löcher 3a, vorzugsweise jeweils zwei, und die inneren 3i, wiederum vorzugsweise zwei, sind grösser als die mittleren Löcher 3m, wiederum vorzugsweise zwei. Der Durchmesser der Löcher 3a, 3i ist dabei vorzugsweise 5mm, derjenige der Löcher 3m 4mm. Die Löcher 3 sind wiederum in Schleifenschenkeln 11c angeordnet. Entlang den Breitseiten des Targets ist das Muster im wesentlichen kreissegmentförmig, wie bei 4 dargestellt, vorzugsweise aufgespannt durch Reihen von Löchern 3m, 3a parallel zur Target-Breitseite. Dieses Muster ergibt einen besonders flachen Erosionsgraben, der unabhängig von der Target-Dicke ist.

**Patentansprüche**

1.  Magnetrontarget aus ferromagnetischem Material, **dadurch gekennzeichnet, dass** es, entlang seiner Zerstäubungsfläche verteilt, ein Muster von Sacklöchern (3) aufweist.

2.  Magnetrontarget nach Anspruch 1, **dadurch gekennzeichnet, dass** die Sacklöcher (3) im wesentlichen entlang mindestens einer in sich geschlossenen Schleife (11, 13), vorzugsweise bezüglich des Targetoberflächenzentrums und/oder mindestens einer Targetoberflächen-Symmetrieachse zentriert, angeordnet sind, vorzugsweise in mindestens zwei der erwähnten in sich geschlossenen Schleifen.

3.  Target nach Anspruch 2, **dadurch gekennzeichnet, dass** zwischen zwei (11a, 11i) in sich geschlossenen Schleifen mindestens eine (13a, 13i) weitere vorgesehen ist, wobei vorzugsweise die Sackloch-Durchmesser der Sacklöcher (3) entlang der weiteren Schleife (13a, 13i) kleiner sind als die entlang der zwei äusseren Schleifen (11a, 11i).

4.  Target nach einem der Ansprüche 1 bis 3, **dadurch gekennzeichnet, dass** das Muster sich zick-zack-förmig vom Targetflächen-Rand zu deren Zentrum hin erstreckende Reihen (40) von Sacklöchern (3) umfasst.

5.  Target nach Anspruch 4, **dadurch gekennzeichnet, dass** es rechteckförmig ist, sich das Zick-zack-Muster quer zu und entlang der Längsseiten erstreckt und dass entlang der Breitseiten das Muster mindestens genähert in Form einer Kreissegmentfläche (4) die Zick-zack-Muster verbindet.

6.  Target nach Anspruch 4 oder 5, **dadurch gekennzeichnet, dass** die Reihen aus Sackbohrungen bestehen, deren äussere (3a) einen grösseren Durchmesser aufweisen als deren innere (3m).

7.  Target nach einem der Ansprüche 1 bis 6, **dadurch gekennzeichnet, dass** es aus Nickel oder einer Nickellegierung, vorzugsweise bei letzterem aus NiFe besteht.

8.  Target nach einem der Ansprüche 1 bis 7, **dadurch gekennzeichnet, dass** die Sackloch-Durchmesser im Bereich von 3mm bis 6mm (beide Grenzen eingeschlossen) liegen.

9.  Magnetronquelle mit einem Target nach einem der Ansprüche 1 bis 8, **dadurch gekennzeichnet, dass** die Sacklochverteilung sich entlang desjenigen Targetbereiches erstreckt, worüber das Tunnelfeld ($\bar{B}$) der Quelle liegt.

10. Magnetronquelle nach Anspruch 9, **dadurch gekennzeichnet, dass** die Sacklochverteilung im wesentlichen symmetrisch zum Ort verschwindender Magnetfeldstärkekomponente ($B_z$) senkrecht zur Targetneufläche (7) des Tunnelfeldes ist.

11. Magnetronsputteranlage mit einer Magnetronquelle nach einem der Ansprüche 9 oder 10, **dadurch gekennzeichnet, dass** die Durchmesser der Sacklöcher so dimensioniert sind, dass keine Hohlkathodenentladung bei Betriebsbedingungen der Anlage auftritt.

12. Verfahren zur Herstellung eines Targets aus ferromagnetischem Material für eine gegebene Magnetronquelle mit gegebenem Tunnelfeld, **dadurch gekennzeichnet, dass** man

    -  den Tunnelfeldverlauf bei Vorsehen einzelner Sacklöcher in der Targetneufläche in Funktion von Lochdurchmesser und/oder ihrer Relativlage zum Tunnelfeld und/oder des Lochprofils und/oder der Lochachsenneigung bezüglich der Targetneufläche und/oder der Targetdik-

kenprofilierung misst oder berechnet und abspeichert,

- diese Tunnelfeldverläufe mehrerer Einzelsacklöcher bei gegebenen Relativlagen zwischen den Löchern und zum Tunnelfeld und Lochdurchmessern, als Anfangsbedingungen, additiv überlagert zum Erhalt eines resultierenden Tunnelfeldverlaufes,

- den resultierenden Tunnelfeldverlauf mit einem SOLL-Tunnelfeldverlauf vergleicht,

- in Funktion des Vergleichsresultates die Parameter-Relativlage der Einzelsacklöcher und/ oder ihre Durchmesser und/oder ihre Lage bezüglich des Tunnelfeldes und/oder ihr Profil und/oder ihre Neigung und/oder die Targetdikkenprofilierung und/oder die Lochanzahl so lange verändert, bis das resultierende Feld mit gegebener Näherung dem SOLL-Feldverlauf entspricht,

- mit den gefundenen Parametern das Einarbeiten von Sacklöchern in die plane Targetzerstäubungsfläche steuert.

13. Anordnung zur Herstellung eines Targets aus ferromagnetischem Material für eine gegebene Magnetronquelle mit gegebenem Tunnelfeld, **dadurch gekennzeichnet, dass** sie umfasst

- eine Eingabeeinheit mit mehreren Ausgängen, woran Feldverteilungskurven abrufbar sind und woran (26), über Stelleingänge, Kurvenparameter (n, v, Φ, y) verstellbar sind,

- eine Verlaufsadditionseinheit (22), welche eingangsseitig mit der Eingabeeinheit wirkverbunden ist und welche ausgangsseitig auf den einen Eingang einer Verlaufsvergleichseinheit (24) führt, an deren zweitem Eingang ein erwünschter Verlauf eingebbar ist und deren Ausgang auf die Stelleingänge an der Eingabeeinheit (26) rückwirkt, wobei weiter die Stelleingänge gesteuert mit einer Ausgabe (30, 32) für die Ansteuerung einer Sacklochfertigungseinrichtung für das Target wirkverbunden sind.

14. Anordnung nach Anspruch 13, **dadurch gekennzeichnet, dass** an der Eingabeeinheit die Anzahl (n) aktivierter Ausgänge über die Stelleingänge verstellbar ist.

## Claims

1. Magnetron target of ferromagnetic material, **char-** **acterised in that** it has a pattern of blind holes (3) distributed along its atomisation surface.

2. Magnetron target according to claim 1, **characterised in that** the blind holes (3) are arranged essentially along at least one closed loop (11, 13), preferably centred in relation to the target surface centre and/or at least one target surface symmetry axis, preferably in at least two of the said closed loops.

3. Target according to claim 2, **characterised in that** between two closed loops (11a, 11i) is provided at least one further loop (13a, 13i), where preferably the diameter of the blind holes (3) along the further loop (13a, 13i) is less than the diameter of those along the two outer loops (11a, 11i).

4. Target according to any of claims 1 to 3, **characterised in that** the pattern comprises rows (40) of blind holes (3) which extend zigzag-like from the target surface edge to its centre.

5. Target according to claim 4, **characterised in that** it is rectangular, the zigzag pattern extends transverse to and along the long sides, and along the short sides the pattern connects the zigzag pattern at least approximately in the form of a circle segment surface (4).

6. Target according to claim 4 or 5, **characterised in that** the rows consist of blind holes, the outer ones of which (3a) have a larger diameter than the inner ones (3m).

7. Target according to any of claims 1 to 6, **characterised in that** it consists of nickel or a nickel alloy, in the latter case preferably NiFe.

8. Target according to any of claims 1 to 7, **characterised in that** the blind hole diameter lies in the range from 3 mm to 6 mm (including both limits).

9. Magnetron source with a target according to any of claims 1 to 8, **characterised in that** the blind hole distribution extends along those target areas over which lies the tunnel field ($\bar{B}$) of the source.

10. Magnetron source according to claim 9, **characterised in that** the blind hole distribution is essentially symmetrical to the site of the vanishing magnetic field intensity components ($B_z$) perpendicular to the target new surface (7) of the tunnel field.

11. Magnetron sputtering apparatus with a magnetron source according to one of claims 9 or 10, **characterised in that** the diameter of the blind holes is dimensioned so that no hollow cathode discharge occurs under the operating conditions of the apparatus.

**12.** Process for production of a target of ferromagnetic material for a given magnetron source with a given tunnel field, **characterised in that**

- where individual blind holes are provided in the target new area, the tunnel field course is measured or calculated and stored as a function of the hole diameter and/or its relative position to the tunnel field and/or the hole profile and/or the hole axis incline in relation to the target new surface and/or the target thickness profiling,
- these tunnel field courses of several individual blind holes with given relative positions between the holes and from the tunnel field and hole diameters as starting conditions, are superposed additively to obtain a resultant tunnel field course,
- the resultant tunnel field course is compared with a nominal tunnel field course,
- as a function of the comparison result, the parameters relative position of the individual blind holes and/or their diameter and/or their position in relation to the tunnel field and/or their profile and/or their incline and/or the target thickness profiling and/or the number of holes are changed until the resulting field corresponds with given approximation to the nominal field course,
- the working of blind holes into the flat target sputtering surface is controlled using the parameters found.

**13.** Arrangement for production of a target of ferromagnetic material for a given magnetron source with a given tunnel field, **characterised in that** it comprises

- an input unit with several outputs at which field distribution curves can be retrieved and on which (26), via regulating inputs, curve parameters (n, v, Φ, y) can be adjusted,
- a course addition unit (22) which on the input side is actively connected with the input unit and on the output side leads to an output of a course comparison unit (24), at the second input of which a desired course can be entered and the output of which reacts on the regulating inputs at the input unit (26), where further the regulating inputs are actively connected under control with an output (30, 32) for controlling a blind hole production device for the target.

**14.** Arrangement according to claim 13, **characterised in that** at the input unit the number (n) of activated outputs can be adjusted via the regulating inputs.

**Revendications**

**1.** Cible de magnétron en matériau ferromagnétique, **caractérisée en ce qu'**elle présente des trous borgnes (3) répartis suivant un certain dessin le long de sa surface de pulvérisation.

**2.** Cible de magnétron selon la revendication 1, **caractérisée en ce que** les trous borgnes (3) sont disposés sensiblement le long d'au moins une boucle fermée (11, 13), de préférence en étant centrés par rapport au centre de la surface de la cible et/ou à au moins un axe de symétrie de surface de cible, de préférence sur au moins deux des boucles fermées mentionnées.

**3.** Cible selon la revendication 2, **caractérisée en ce qu'**il est prévu, entre deux (11a, 11i) boucles fermées, au moins une autre boucle (13a, 13i), le diamètre des trous borgnes (3) le long de cette autre boucle (13a, 13i) étant plus petit que le long des deux boucles extérieures (11a, 11i).

**4.** Cible selon l'une des revendications 1 à 3, **caractérisé en ce que** le dessin comprend des rangées (40) de trous borgnes (3) qui s'étendent en zigzag du bord de la surface cible vers le centre de celle-ci.

**5.** Cible selon la revendication 4, **caractérisé en ce qu'**elle est rectangulaire et le dessin en zigzag s'étend transversalement par rapport aux grands côtés et le long de ceux-ci, et **en ce que** le long des petits côtés, le dessin relie les dessins en zigzag au moins approximativement en forme de surface de segment de cercle (4).

**6.** Cible selon la revendication 4 ou 5, **caractérisée en ce que** les rangées se composent de perçages borgnes, les perçages extérieurs (3a) ayant un plus grand diamètre que les perçages intérieurs (3m).

**7.** Cible selon l'une des revendications 1 à 6, **caractérisée en ce qu'**elle se compose de nickel ou d'un alliage de nickel et de préférence, dans ce dernier cas, de NiFe.

**8.** Cible selon l'une des revendications 1 à 7, **caractérisé en ce que** le diamètre des trous borgnes est situé dans la plage de 3 mm (inclus) à 6 mm (inclus).

**9.** Source de magnétron avec une cible selon l'une des revendications 1 à 8, **caractérisée en ce que** la répartition des trous borgnes s'étend le long de la zone de cible sur laquelle se trouve le champ en forme de tunnel (B) de la source.

**10.** Source de magnétron selon la revendication 9, **caractérisé en ce que** la répartition des trous borgnes est sensiblement symétrique par rapport à l'endroit où la composante d'intensité de champ magnétique $(B_z)$ devient infiniment petite, perpendiculairement à la nouvelle surface cible (7) du champ en forme de tunnel.

11. Installation de pulvérisation cathodique par magnétron avec une source de magnétron selon la revendication 9 ou 10, **caractérisée en ce que** le diamètre des trous borgnes est dimensionné pour qu'il n'y ait pas de décharge de cathode creuse dans les conditions de fonctionnement de l'installation.

12. Procédé pour fabriquer une cible en matériau ferromagnétique pour une source de magnétron donnée, avec un champ en forme de tunnel donné, **caractérisé**

   - **en ce qu'**on mesure ou on calcule et on met en mémoire la courbe du champ en forme de tunnel, en prévoyant des trous borgnes individuels dans la nouvelle surface cible, en fonction du diamètre des trous et/ou de leur position relative par rapport au champ en forme de tunnel et/ou du profil des trous et/ou de l'inclinaison de leur axe par rapport à la nouvelle surface cible et/ou au profil d'épaisseur de la cible,
   - **en ce qu'**on superpose par addition, comme conditions initiales, ces courbes de champ en forme de tunnel de plusieurs trous borgnes individuels, pour des positions relatives données entre les trous et par rapport au champ en forme de tunnel et pour des diamètres de trous donnés, pour obtenir une courbe de champ en forme de tunnel résultante,
   - **en ce que** l'on compare la courbe de champ en forme de tunnel résultante à une courbe de champ en forme de tunnel théorique,
   - **en ce que**, en fonction du résultat de la comparaison, on modifie les paramètres constitués par la position relative des trous borgnes individuels et/ou leur diamètre et/ou leur position par rapport au champ en forme de tunnel et/ou leur profil et/ou leur inclinaison et/ou le profil d'épaisseur de cible et/ou le nombre de trous, jusqu'à ce que le champ résultant corresponde suivant une approximation donnée à la courbe de champ théorique,
   - **en ce que**, à l'aide des paramètres trouvés, on commande la réalisation de trous borgnes dans la surface de pulvérisation de cible plane.

13. Dispositif pour fabriquer une cible en matériau ferromagnétique pour une source de magnétron donnée, avec un champ en forme de tunnel donné, **caractérisé en ce qu'**il comprend

   - une unité d'entrée avec plusieurs sorties, au niveau de laquelle des courbes de répartition de champ peuvent être appelées et au niveau de laquelle (26) des paramètres de courbe (n, v, Φ, y) peuvent être réglés par l'intermédiaire d'entrées de réglage,
   - une unité d'addition de courbes (22) qui est en relation fonctionnelle, côté entrée, avec l'unité d'entrée et qui mène, côté sortie, à une première entrée d'une unité de comparaison de courbes (24) à la seconde entrée de laquelle une courbe souhaitée peut être entrée et dont la sortie réagit sur les entrées de réglage au niveau de l'unité d'entrée (26), les entrées de réglage étant en relation fonctionnelle de manière commandée avec une sortie (30, 32) pour commander un dispositif de réalisation de trous borgnes pour la cible.

14. Dispositif selon la revendication 13, **caractérisé en ce que**, au niveau de l'unité d'entrée, le nombre (n) de sorties activées est réglable par l'intermédiaire des entrées de réglage.

FIG.1a

FIG.1b

FIG.1c

FIG.1d

FIG.1e

FIG.1f

FIG.2

FIG.3

FIG.4

FIG.5

gemessene Werte
berechnete Kurve

FIG. 6

FIG. 7

FIG. 8

EP 0 888 464 B1

FIG. 9

FIG. 10

FIG. 11

FIG.12